# EUROPEAN PATENT APPLICATION

(11) **EP 1 876 711 A1**
(43) Date of publication of application: **09.01.2008**
(21) Application number: 07111133.0
(22) Date of filing: 27.06.2007
(51) Int. Cl.: H03K 17/96

(54) **Touch sensor**

(30) Priority: 07.07.2006 US 482639
(71) Applicant: Tyco Electronics Canada Ltd., Markham, ON L3R 1E1 (CA)
(72) Inventor: Paun, Traian, Markham Ontario L6E 1S7 (CA); Atanassov, Filip, Oakville Ontario L6H 7K3 (CA)
(74) Representative: Townsend, Stephen

(57) **Abstract**

A touch sensor includes a keyboard having a key (K1 to K16) defining a touch sensing location, and control circuitry (40) associated with the key (K1 to K16). The control circuitry includes a transistor (Q17 to Q20), and the key controls the transistor (Q1 to Q16) based on a touch event. A pulse signal generator (50) is connected to the control circuitry (40) and generates pulsed signals for transmission to the control circuitry. The pulsed signals power the transistor (Q17 to Q20), and the transistor (Q1 to Q16) outputs a touch signal when a touch event occurs at the associated key (K1 to K16) and the transistor outputs a non-touch signal when no touch event occurs at the associated key. An analyzer (46) is connected to the control circuitry (40) and receives from the transistor (Q1 to Q16) one of the touch signal indicating the touch event and the non-touch signal indicating the no touch event.

## Description

This invention relates generally to touch sensors, and more specifically, to control systems and methods for capacitive touch sensors.

Conventional capacitive touch sensing systems include a keyboard having multiple keys. Each key includes a conductive pad overlaid by a dielectric element. The conductive pad is connected to control circuitry that monitors the current level of the pad. Typically, the pad is supplied with a current having a constant amplitude, and when the key is touched by a user, a portion of that current is drawn to the user. The key touch represents a change to the circuit capacitance and results in a current level change.

One problem with conventional touch sensing systems is that a faulty touch may be erroneously detected by the touch sensing system. These faulty touches are caused by various problems, such as interference caused by noise, unequal key sensitivities caused by manufacturing or environmental factors, drift in key sensitivity due to environmental factors like temperature or humidity, and touches by non-user objects such as metal objects, water, or animals. Faulty touches may cause the touch sensing system to activate a controlled device in an unwanted manner.

At least some known touch sensing systems have addressed one or more of these problems. For example, a prior art touch sensing system for detecting faulty touches is described in U.S. Pat No. 5,760,715 ('715). In the '715 patent, a padless touch sensor is used for detecting a touch at a sensing location onto a dielectric element by a user coupled to earth. The sensor includes a conductive plate having a predetermined potential applied thereto. Simultaneously, test pulses are produced into earth. When the user touches the dielectric element at the sensing location, a potential variation in the conductive plate is produced during a test pulse due to a capacitive circuit formed between earth, the user and the sensor. As such, foreign matter or objects placed directly on top of the dielectric element will not erroneously produce a touch condition.

In one aspect, a touch sensor is provided including a keyboard having a key defining a touch sensing location, and control circuitry associated with the key. The control circuitry includes a transistor, and the key controls the transistor based on a touch event. A pulse signal generator is connected to the control circuitry and generates pulsed signals for transmission to the control circuitry. The pulsed signals power the transistor, and the transistor outputs a touch signal when a touch event occurs at the associated key and the transistor outputs a non-touch signal when no touch event occurs at the associated key. An analyzer is connected to the control circuitry and receives from the transistor one of the touch signal indicating the touch event and the non-touch signal indicating the no touch event.

Optionally, the transistor may output the touch signal and the no-touch signal only after the transistor is powered by the pulsed signals, and the transistor is un-powered and provides no output to the analyzer between pulse signals. A base of the transistor may be capacitively coupled to the user when the user is touching the touch sensing location. A current passing through the transistor may be different during the touch event than during the no touch event. Optionally, the analyzer may compare one of a capacitance change between the touch signal and the non-touch signal, an amplitude of the touch signal with an amplitude of the non-touch signal, and a time for the touch signal to reach a predetermined value with a time for the non-touch signal to reach the same predetermined value.

In another aspect, a touch sensor is provided including a keyboard having multiple keys arranged in a matrix having rows of keys and columns of keys, each key defining a touch sensing location, and control circuitry associated with each of the keys. The control circuitry includes a transistor for each key and each key controls the transistor based on a touch event. A pulse signal generator is connected to the control circuitry and generates pulsed signals for transmission to the control circuitry associated with each of the keys. The pulsed signals power the transistors, and each transistor powered by the pulsed signals outputs a touch signal when a touch event occurs at the associated key and a non-touch signal when no touch event occurs at the associated key. An analyzer is connected to the control circuitry and receives from the transistors one of the touch signal indicating the touch event and the non-touch signal indicating the no touch event.

Optionally, the pulse signal generator may sequentially apply pulses to keys in a row by row order, and the analyzer may sequentially analyze the outputs of the transistors in a column by column order.

In a further aspect, a method of detecting a touch event using a touch sensor having a key and associated control circuitry including a transistor is provided. The method includes sending pulsed signals from a controller to the control circuitry associated with the key, powering the transistor with the pulsed signal, and once powered, generating a touch signal when a touch event occurs at the key and generating a non-touch signal when no touch event occurs at the key. The method also includes analyzing the generated signal from the transistor.

Figure 1 is a schematic view of a capacitive touch sensor formed in accordance with an exemplary embodiment of the present invention.

Figure 2 is a schematic circuit diagram of the capacitive touch sensor shown in Figure 1.

Figure 3 is a timing chart of an exemplary operation of the capacitive touch sensor shown in Figure 1.

Figure 4 is a schematic circuit diagram of an alternative capacitive touch sensor formed in accordance with an alternative embodiment of the present invention.

Figure 5 is a schematic view of an exemplary device using the touch sensor shown in Figure 1.

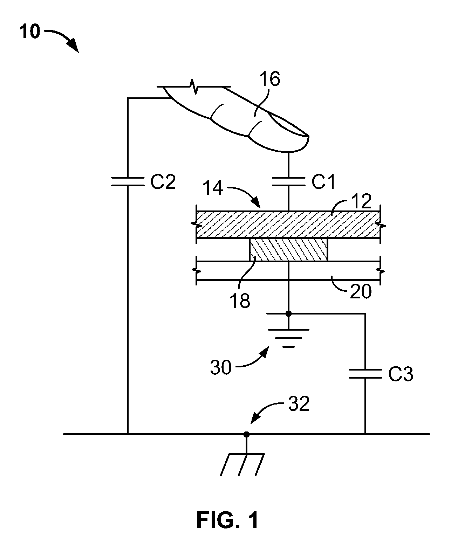

Figure 1 is a schematic view of a capacitive touch sensor 10 according to the present invention. The touch sensor 10 is mounted under a dielectric element 12 and is illustrated in a "touch" condition since a sensing location 14 of the dielectric element 12 is touched by a finger 16 of a user. A touch event occurs when a user physically touches the sensing location 14 or when a user is in close proximity to the sensing location 14, such that the user is capacitively interacting with the touch sensor 10. The touch sensor 10 includes a conductive pad 18 located under the dielectric element 12. The pad 18 is in registry with the sensing location 14 on the dielectric element 12. The touch sensor 10 also includes a circuit board 20 having control circuitry thereon which defines a touch circuit. The pad 18 is connected to the circuit board 20. Optionally, the pad 18 may be a solid conductive pad or the pad 18 maybe a plurality of conductive circuit board traces on the circuit board 20 concentrated at the sensing location 14.

The sensing location 14, the corresponding conductive pad 18 and the touch circuitry associated with the pad 18 are referred to as a "key". If appropriate, markings may be provided to indicate to the user the exact location where the finger 16 has to touch to achieve a touch condition at the key. Of course, a person skilled in the art would realize that the term "finger" may be substituted for any body part that can be used for touching a key. Either a single key, or a plurality of keys, are arranged to define a keyboard, which may be used for home, office or industrial use.

In operation, the touch circuit uses a plurality of distributed capacitances to detect a touch of the key. The touch circuit uses the capacitor, having a capacitance C1, created between the user's finger 16 and the pad 18 to detect a touch event. The touch circuit also uses the capacitor, having a capacitance C2, created between the user's body and conductive objects such as earth ground or virtual ground 30 to detect a touch event. The touch circuit further uses the capacitor, having a capacitance C3, created between a circuit ground 32 of the touch circuit and the earth or virtual ground 30 to detect a touch event. Typically, distributed capacitances C2 and C3 have values that are hundreds of times larger than the distributed capacitance C1. Optionally, the distributed capacitance C1 has a value ranging between 10 picofarad (pf) and 0.5 pf, however, the touch circuit is in no way limited to such a value range.

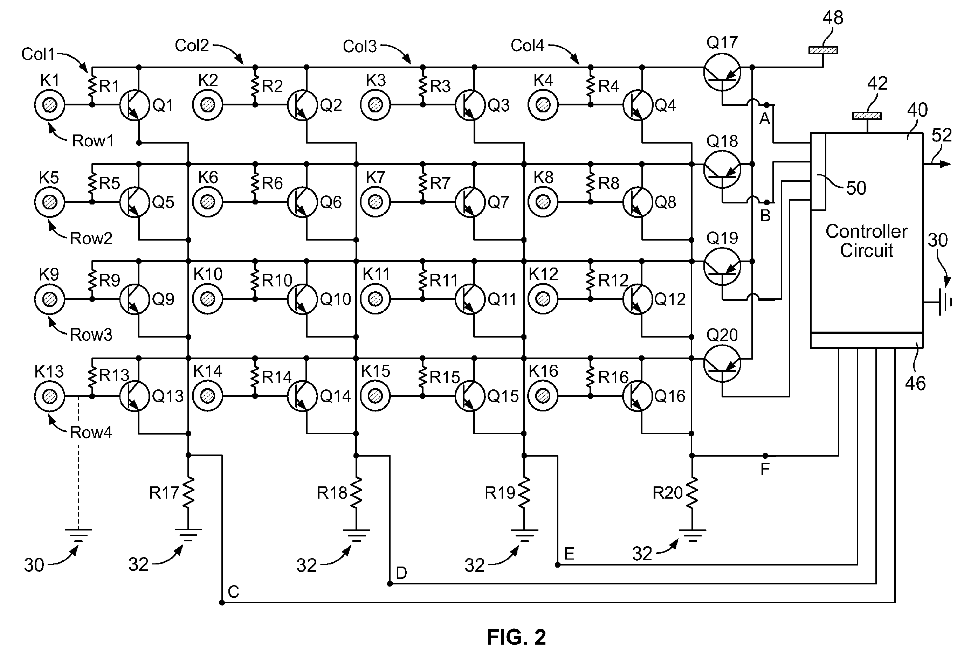

Figure 2 is a schematic circuit diagram of the touch circuit for the touch sensor 10. In the illustrated embodiment, the touch sensor 10 includes multiple keys arranged in a matrix. Optionally, the keys may be arranged in a grid pattern of rows and columns. It is realized that any number of keys may be included in the touch sensor 10, and the touch sensor 10 may include any number of rows and columns of keys. In the illustrated embodiment, sixteen keys are provided in four rows and four columns. The keys are identified as K1 through K16. The rows are identified as ROW1 through ROW4. The columns are identified as COL1 through COL4. The touch circuit associates a resistor and a transistor with each key. The resistors are identified as R1 through R16, which correspond with keys K1 through K16, respectively. The transistors are identified as Q1 through Q16, which correspond with keys K1 through K16, respectively. Each key K1 through K16 is connected within the touch circuitry in parallel with each other key within the same row.

The touch sensor 10 includes a controller 40 for detecting a touch event by a user. The controller 40 is connected to a supply voltage 42 and the controller is also connected to a circuit ground 44. The controller 40 is further connected to each row ROW1 through ROW4 and to each column COL1 through COL4. In one embodiment, the input or feedback from each column COL1 through COL4 is analyzed by an analyzer portion 46 of controller 40. Alternatively, a separate analyzer may be provided and connected to each column. Optionally, a supply transistor may be connected between the controller 40 and each row of keys ROW1 through ROW4. These supply transistors are identified as Q17 through Q20, wherein Q17 is connected between the controller 40 and ROW1; Q18 is connected between the controller 40 and ROW2; Q19 is connected between the controller 40 and ROW3; and Q20 is connected between the controller 40 and ROW4. Additionally, an input of each supply transistor Q17 through Q20 is connected to a supply voltage 48. In operation, the controller 40 selectively controls or selectively activates the supply transistors Q17 through Q20 to connect the supply voltage 48 to the corresponding rows of keys ROW1 through ROW4, respectively.

The controller 40 may include a pulse signal generator 50 that generates pulse signals and sequentially sends the pulse signals to one of the transistors Q17 through Q20. The pulse signal generator 50 applies pulse signals to a single row of keys at a time. Optionally, the pulse signal generator 50 sends a series of pulse signals to one of the transistors Q17 through Q20 before sending a series of pulse signals to a different one of the transistors Q17 through Q20. For example, the pulse signal generator 50 may send four pulse signals to one row before sending four pulse signals to the next row. Once the pulse signals are sent, the particular transistor Q17 through Q20 is powered or activated, and the supply voltage 48 is connected to the corresponding row of keys ROW1 through ROW4, respectively. The supply voltage 48 selectively powers or energizes the transistors Q1 through Q16 associated with the keys K1 through K16 for detecting a possible touch at the keys K1 through K16. For example, the supply voltage 48 is connected to the base of the transistors Q1 through Q16 to power the transistors. Optionally, the supply voltage is also connected to the input of the transistors Q1 through Q16.

Once powered, feedback information relating to a touch event or a no touch event is transmitted back to the controller 40 from each key. A touch signal is sent to the controller 40 when a touch event is occurring. A non-touch signal is sent to the controller 40 when no touch event or a no touch situation is occurring. The feedback information may relate to a change in capacitance or a capacitance indicative of a touch; the feedback signal may relate to the time to receive a signal of a particular value; or the feedback information may relate to an amplitude of a signal at a predetermined time to indicate that a touch has occurred. The feedback information for a touch event is different than the feedback information for a no touch event. As such, the controller 40 is able to differentiate between the feedback information to determine if a touch event is occurring.

The feedback information is communicated from the key along the corresponding column COL1 through COL4 and back to the controller 40. Optionally, the feedback information is transmitted from an output of each transistor to the controller 40. The controller 40 is able to uniquely identify which key has been touched by a user by determining the row that is being signaled or pulsed and interpreting the feedback information from the columns. By way of example, if the controller 40 is generating pulse signals at row ROW3, and a touch signal is being identified at column COL2, then key K10 is being touched.

The touch circuit grounds each column to the circuit ground 32. Optionally, a resistor may be connected between each column of keys COL1 through COL4 and the circuit ground 32. These resistors are identified as R17 through R20, wherein R17 is connected between COL1 and the circuit ground 32; R18 is connected between COL2 and the circuit ground 32; R19 is connected between COL3 and the circuit ground 30; and R20 is connected between COL4 and the circuit ground 32. Alternatively, the resistors R17 through R20 may be connected to earth ground 30.

With reference to one of the keys, for example key K1, during use the current communicated to ROW1 from the supply voltage 48 is sent to resistor R1, which lowers the current to a value that changes can easily be measured when capacitance C1 is created between the user and the touch circuit. Optionally, the resistor R1 acts as a bias resistor for the transistor Q1. The resistor R1 is connected to the base of the transistor Q1, and the current charges or powers the transistor Q1. As the user approaches the key K1, the capacitance C1 is increased and a fraction of the current passing to the base of the transistor Q1 is diverted to the lower impedance of the user's body. The missing current, which may be identified by a change in the touch signal, is analyzed by the controller 40 to determine that a touch situation has occurred. For example, a change in capacitance or a capacitance indicative of a touch may indicate that a touch has occurred. Optionally, the time to receive a signal of a particular value may indicate that a touch has occurred, wherein the time is increased if a touch situation is occurring. Alternatively, an amplitude of a signal at a predetermined time may indicate that a touch has occurred, wherein the amplitude is lower at the predetermined time if a touch situation is occurring.

An exemplary operation of the touch sensor 10 is described herein. In operation, the controller 40 sequentially pulses the touch circuitry to determine which, if any, key is being touched. The controller 40 systematically monitors the keys, one at a time, to determine if a touch event is occurring at a given key. In an exemplary operation, the controller 40 first determines if a touch event is occurring at key K1. The controller 40 sends a pulse signal to ROW1 via transistor Q17. Once the pulse signal activates the transistor Q17, a current is sent to ROW1 from the supply voltage 42. Each of the other rows (i.e. ROW2, ROW3, and ROW4) does not receive a current, and each of the transistors in those rows (i.e. Q5 through Q16) is un-powered and remains de-activated, such that those transistors do not send any signals to the controller 40 for analysis.

The controller 40 monitors COL1 for feedback information. In a no touch situation, in which a user is not touching the key K1, the pulse signal or current transmitted to the key K1 is received and amplified by the transistor Q1. A non-touch signal is then output from an output of the transistor Q1 and communicated to the controller 40 for analysis. Optionally, the pulse signal is communicated for a predetermined pulse time. For example, because the transistor Q1 is in a de-activated state and un-powered prior to receiving the pulse signal, the transistor Q1 has a wake-up time that lasts for a predetermined wake-up time, such as, for example, five microseconds. As such, the pulse signal is activated for the predetermined pulse time, which is longer than the wake-up time, such as, for example, fifty microseconds. Optionally, the wake-up time may provide a delay in the controller 40 receiving the feedback information. The wake-up time may also provide inaccurate feedback information to the controller 40. As such, the controller 40 may disregard the feedback information gathered during the wake-up time.

If a touch event is occurring, in which a user is touching the key K1, the feedback information provided to the controller 40 is different than when a no touch situation is occurring. As such, the controller 40 is able to differentiate between a touch event and a no touch situation. Optionally, the controller 40 may include provisions or control algorithms to facilitate differentiating between the touch event and the no touch situation. At least some of these control algorithms will be described in further detail below. The controller 40 may also include different modules that lower interference or reduce noise to better differentiate between the touch situation and the no touch situation. The controller 40 may include modules that provide self-calibration to compensate for various parameters such as humidity or temperature to aide in differentiating between the touch situation and the no touch situation. Other modules may be included that provide equalization between each of the keys, or a false activation detection to help differentiate between the touch situation and the no touch situation.

When a touch is detected at COL1, the controller 40 may provide an output or perform a function at output 52. The output or function performed depends on the particular application touch sensor 10 is used for. In the exemplary embodiment, once the touch is detected at key K1, controller 40 performs a false activation check to determine if a touch is occurring. Controller 40 will again send a pulse signal to ROW1, and controller 40 will again monitor COL1 for feedback information. Optionally, controller 40 consecutively receives a predetermined number of positive indications of a touch to determine that a touch is actually occurring. In an alternative embodiment, rather than re-checking key K1, controller 40 will continue normal operation and sequentially check all of the keys K2 through K16, and then re-checks each of the keys again.

Under normal operating conditions, when a no touch situation is detected at key K1, controller 40 continues to sequentially check each of the keys K1 through K16. For example, after key K1 is checked, controller 40 then determines if a touch is occurring at key K2. The controller 40 sends a pulse signal to ROW1, and controller 40 monitors COL2 for feedback information. Once controller 40 has determined the status of key K2, controller 40 then determines if a touch is occurring at key K3. The controller 40 sends a pulse signal to ROW1, and controller 40 monitors COL3 for feedback information. Once controller 40 has determined the status of key K3, controller 40 then determines if a touch is occurring at key K4. The controller 40 sends a pulse signal to ROW1, and controller 40 monitors COL4 for feedback information.

Once the status of each key K1 through K4 in ROW1 has been determined, the controller 40 determines the status of the keys K5 through K8 in ROW2 in a similar manner. The controller 40 sends a pulse signal to ROW2 via transistor Q18. Once the signal activates the transistor Q18, a current is sent to ROW2 from the supply voltage 42. Each of the other rows (i.e. ROW1, ROW3, and ROW4) does not receive a current, and each of the transistors in those rows (i.e. Q1 through Q4 and Q9 through Q16) is not powered and remains de-activated. The controller 40 sequentially checks each key K5 through K8 by sequentially monitoring COL1 through COL4, respectively, for feedback information. A similar process is followed for determining the status of keys K9 through K16. Once each of the keys K1 through K16 have been sequentially checked, the process is again repeated for key K1. In an alternative embodiment, the order of checking the keys K1 through K16 may be accomplished in a different pattern, such as by sequentially checking each key in one row before moving to the next row or in a randomized pattern.

As described above, the controller 40 may include various modules that affect an overall performance of touch sensor 10. Optionally, the controller 40 may include a jittering module that generates a key scanning signal or pulse signal with a relatively low amplitude spectrum to minimize interference between the key scanning signal and external powerful noise signals. The jittering module may include a filter for filtering signals that are not within the amplitude spectrum of the key scanning signal. Additionally, with scanning signals having lower amplitudes, changes in the signal may be easier to detect, such as during a touch situation when a portion of the current is diverted to the users body.

The controller 40 may also include a noise blanking module that stops touch signals from being analyzed or monitored to prevent faulty activation. For example, when powerful electrical noises are generated in the vicinity of touch sensor 10, faulty signals may be transmitted to the controller 40. The noise blanking module prevents faulty activation or output from the controller 40 based on these faulty signals. Optionally, the noise blanking module may use a scanning feedback signal to detect external noise or the noise blanking module may use an external sensor to detect external noise. As such, the controller 40 operates more reliably in noisy environments.

The controller 40 may include a self calibration module that compensates each keys sensitivity for various environmental factors, such as temperature or humidity. The self calibration module uses a low pass filter that monitors the touch signal for each key over a period of time. If a drift is detected, then the keys sensitivity may be changed to compensate for such drift.

As indicated above, the controller 40 may include a false key activation module that determines if a touch situation is occurring and is used to detect and eliminate quick capacitance changes or random noises. The false key activation module requires multiple consecutive positive touch signals to confirm that a touch actually occurred. The false key activation module also ensures that the user's finger 16 (shown in Figure 1) remains on the key for a predetermined amount of time and is not an accidental touching.

The controller 40 may include a ground loop detection module that can detect if a touch is made by a user or if the touch is made by a non-user object, such as a metal object or a drop of water that has inadvertently landed on the touch sensing location 14 (shown in Figure 1). Optionally, one of the keys may be replaced by a ground loop detection circuit, such as the optional circuit shown at key K13 illustrated in Figure 2. When the ground loop detection circuit is used, no touch location would be provided at key 13. The base of the transistor Q13 is connected to the earth or virtual ground 30. The controller 40 analyzes the ground loop detection circuit in a similar manner as each of the other keys. The current through the transistor Q13 is measured and stored in the controller 40 as a reference for comparison with the signals from the other keys. For example, if the measured signal received at one of the keys corresponds to the signal from the ground loop detection circuit, than a touch event is identified. However, if the measured signal at one of the keys does not correspond to the signal from the ground loop detection circuit, than a non-user touch may be occurring. As such, a non-touch situation will be determined. Additionally, the ground loop detection module may be used to determine a size of the user that is touching the touch sensor 10 based on the capacitance change. Optionally, the controller 40 may resist outputting control signals based on the size of the person. For example, if the controller 40 determines that a child is trying to touch the touch sensor 10, then the controller 40 may refuse to send an output to a connected device.

The controller 40 may include an equalization module that provides equal key sensitivity. Typically, some keys in a keyboard may have different sensitivities due to manufacturing or environmental tolerances or due to the keys position on the keyboard, or due to the size of the key. The sensitivity may also be affected by a thickness or type of material of the dielectric element 12 (shown in Figure 1). The equalization module develops a sensitivity map for the keyboard by using a reference or calibration signal to record a threshold value for each key and then uses that threshold value to create an even sensitivity keyboard. Optionally, the equalization module decreases each key's sensitivity until the reference signal is detected. Alternatively, the equalization module increases each key's sensitivity until the key no longer detects the reference signal. Once the threshold value is determined, the value is saved in a memory or EEPROM to develop the sensitivity map.

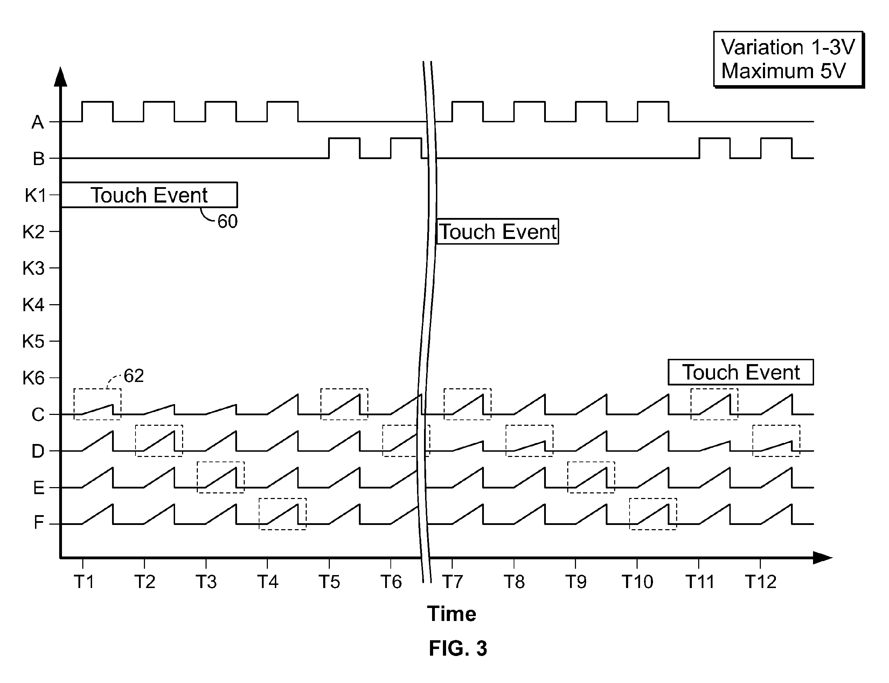

Figure 3 is a timing chart of an exemplary operation of the touch sensor 10. The chart illustrates pulse signals at a plurality of nodes and illustrates key touch events 60 at a sampling of identified keys (i.e. keys K1 through K6). However, it is understood that the controller 40 would analyze touch events 60 for all of the keys provided in the keyboard. The chart illustrates pulse signals at node A and at node B, which correspond to circuitry associated with ROW1 and ROW2, respectively. However, it is understood that the controller 40 would analyze pulse signals for all of the rows provided in the keyboard. The chart illustrates pulse signals at node C, node D, node E and node F, which correspond to circuitry associated with columns COL1 through COL4, respectively. However, it is understood that the controller 40 would analyze pulse signals for all of the columns provided in the keyboard. The chart also illustrates the touch signal being analyzed by the controller 40 with dashed box identified by reference numeral 62.

In operation, as described above, the controller 40 sequentially applies pulses to the keys in a row by row order. As illustrated in Figure 3, the controller 40 applies a series of four pulses to each row, and then applies another series of pulses to the next row. For example, starting at time T1, the node A identifies four pulses and then does not receive anymore pulses for a predetermined time. After the four pulses are sent to node A, node B then receives a series of four pulses, however only two of the pulses are illustrated in Figure 3. Then four pulses would be applied to ROW3, followed by four pulses to ROW4.

The controller 40 receives and analyzes feedback information from each of the keys in the form of signals at each of the columns COL1 through COL4. Notably, because each key in a row receives the pulsed signal from the controller 40, the controller 40 will receive feedback information for analysis from each column. The signal received will either be a touch signal indicating a touch event at that key or a non-touch signal indicating no touch event at that key. The touch signals and the non-touch signals are different than one another so that the controller 40 can identify a touch event. Optionally, the non-touch signal may be triangular in shape and may have a ramped portion. The height of the ramped portion may correspond to an amplitude of the signal. Optionally, the frequency of the signals corresponds to the pulsed signal sent form the controller 40. The touch signal is unique from the non-touch signal because the touch event by the user changes the pulsed signal. Optionally, the change in signal may be caused by the capacitive coupling of the user to the key. In the illustrated embodiment, the touch signal includes a ramped portion that has a different slope as compared to the non-touch signal. Optionally, the height of the signal is different during a touch event as the amplitude may be lower at the key during the touch event. While the shape of the signal illustrated in Figure 3 is triangular, it is noted that the signal may have a different shape such as a rectangular shape, a square wave shape, a curved shape, and the like. Additionally, the shape of the touch signal may be different than the touch signal illustrated in Figure 3.

As indicated above, the controller 40 sequentially analyzes the outputs of the transistors in a column by column order. The outputs may be either the touch signal or the non-touch signal. In the illustrated embodiment, at time T1, the controller 40 is analyzing the signal from column COL1, as shown by the signal at node C. The signal is a touch signal, as illustrated in the dashed box 62, because a touch event 60 is occurring at key K1. While each of the other columns COL2 through COL4 are receiving a signal at time T1, as shown by the signal at nodes D, E and F, the controller 40 is not analyzing the signals at those columns. Alternatively, the controller 40 may analyze multiple signals at a time from multiple columns. In another alternative embodiment, a separate analyzer may be provided for analyzing the signals. At time T2, the controller 40 is analyzing the signal from column COL2, as shown by the signal at node D. The signal is a non-touch signal because no touch event is occurring at key K2. While key K1 is still indicating a touch signal at time T2, the controller 40 is only analyzing the status of key K2. At time T3, the controller 40 is analyzing the signal from column COL3, as shown by the signal at node E. The signal is a non-touch signal because no touch event is occurring at key K3. At time T4, the controller 40 is analyzing the signal from column COL4, as shown by the signal at node F. The signal is a non-touch signal because no touch event is occurring at key K4.

At time T5, the controller 40 is pulsing ROW2, and the controller 40 is analyzing the status of key K5 by analyzing the signal at node C. A non-touch signal is provided at node C, even though key K1 is being touched. As such, the controller 40 is able to uniquely identify the key being touched by pulsing a single row of keys and analyzing a single column of keys. In the illustrated embodiment, the controller 40 also identifies a touch signal at time T8 by analyzing the signal at key K2 and at time T12 by analyzing key K6. It is noted that multiple keys may be touched at any one time, and the controller 40 is able to uniquely identify each of the keys being touched. It is also noted that the pulse rate may be sufficiently fast to provide many pulses to each key during a normal touch event to better identify the touch event and identify possible false or faulty touches.

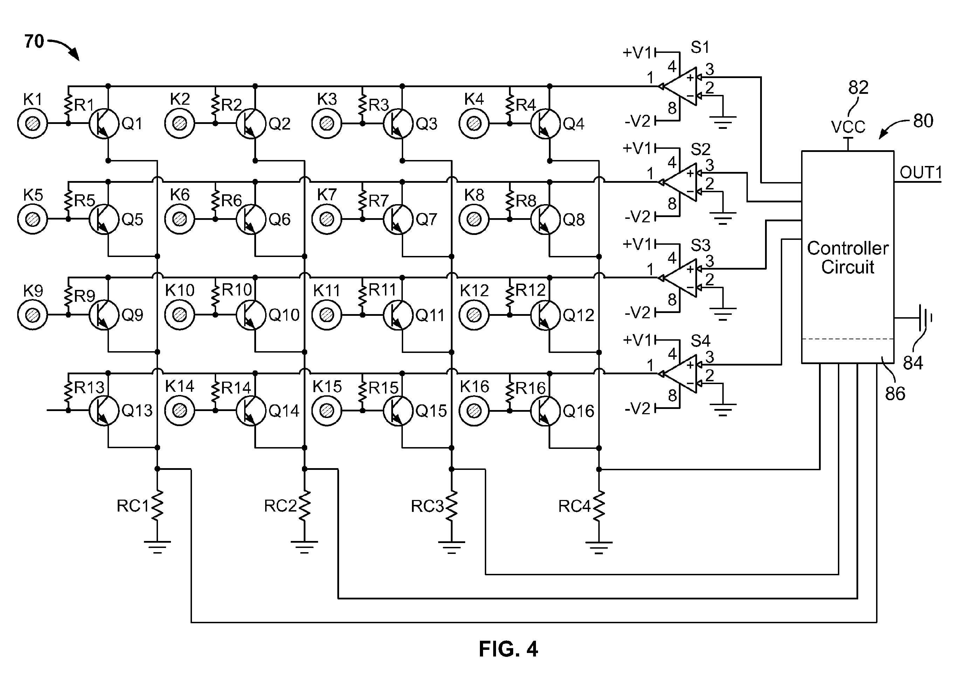

Figure 4 is a schematic circuit diagram of an alternative touch circuit for an alternative touch sensor 70. In the illustrated embodiment, the touch sensor 70 includes multiple keys arranged in a matrix. Optionally, the keys may be arranged in a grid pattern of rows and columns. It is realized that any number of keys may be included in the touch sensor 70, and the touch sensor 70 may include any number of rows and columns of keys. In the illustrated embodiment, sixteen keys are provided in four rows and four columns. The keys are identified as K1 through K16. The rows are identified as ROW1 through ROW4. The columns are identified as COL1 through COL4. Optionally, the touch circuit associates a resistor and a transistor with each key. However, the touch circuit may include other components that function to identify a touch event at one of the keys. The resistors are identified as R1 through R16, which correspond with keys K1 through K16, respectively. The transistors are identified as Q1 through Q16, which correspond with keys K1 through K16, respectively. Each key K1 through K16 is connected within the touch circuitry in parallel with each other key within the same row.

The touch sensor 70 includes a controller 80 for detecting a touch event by a user. The controller 80 is connected to a supply voltage 82 and the controller is also connected to a circuit ground 84. The controller 80 is further connected to each row ROW1 through ROW4 and to each column COL1 through COL4. In one embodiment, the input or feedback from each column COL1 through COL4 is analyzed by an analyzer portion 86 of controller 80. Alternatively, a separate analyzer may be provided and connected to each column. Optionally, a switch may be connected between the controller 80 and each row of keys ROW1 through ROW4. These switches are identified as S1 through S4, wherein S1 is connected between the controller 80 and ROW1; S2 is connected between the controller 80 and ROW2; S3 is connected between the controller 80 and ROW3; and S4 is connected between the controller 80 and ROW4. Optionally, the switches S1 through S4 represent operational amplifiers. A first input of each switch S1 through S4 is connected to the controller 80, and operating signals may be transmitted from the controller 80 to the respective switches S 1 through S4. A second input of each switch S 1 through S4 is connected to ground. Additionally, each switch is connected to two power supplies. The power supplies are identified generally as V and V2. Optionally, each switch S through S4 is connected to the same two power supplies such that each switch S 1 through S4 is supplied with the same voltage from each power supply V1 and V2. Alternatively, the power supplies may be different for each switch S through S4. Optionally, V 1 may be a positive power supply and V2 may be a negative power supply. Optionally, the voltage of V1 and V2 may be equal but opposite. In one embodiment, V1 may be +15 volts and V2 may be -15 volts. However, V1 and V2 may have different voltage levels than +15 and -15, respectively.

In operation, the controller 80 selectively controls or selectively activates the switches S1 through S4 to connect the power supplies V1 and V2 to the corresponding rows of keys ROW1 through ROW4, respectively. When no signal is sent to a row, the switch is outputting power from V2. When the controller sends a signal to one of the switches, for example S1, then the switch S1 is outputting power from V1 to each of the keys K1 through K4. Once powered, feedback information relating to a touch event or a no touch event is transmitted back to the controller 80 from each key K1 through K4. A touch signal is sent to the controller 80 when a touch event is occurring. A non-touch signal is sent to the controller 80 when no touch event or a no touch situation is occurring. The feedback information may relate to a change in capacitance or a capacitance indicative of a touch; the feedback signal may relate to the time to receive a signal of a particular value; or the feedback information may relate to an amplitude of a signal at a predetermined time to indicate that a touch has occurred. The feedback information for a touch event is different than the feedback information for a no touch event. As such, the controller 80 is able to differentiate between the feedback information to determine if a touch event is occurring. Additionally, the voltage difference between V1 and V2 is selected to provide a noticeable or measurable feedback signal. For example, a larger voltage difference corresponds to a larger feedback signal, and a variation in the feedback signal is more easily recognized and/or measured for a larger feedback signal. Optionally, the voltage of V1 and/or V2 may be controlled to limit a maximum feedback signal to the controller 80. In one embodiment, the voltage of the feedback signal may be limited to a maximum of 5 volts, however the maximum may depend on the type or size of controller 80.

In a similar manner as the touch sensor 10, the feedback information for the touch sensor 70 is communicated from the key along the corresponding column COL1 through COL4 and back to the controller 80. Optionally, the feedback information is transmitted from an output of each transistor to the controller 80. The controller 80 is able to uniquely identify which key has been touched by a user by determining the row that is being signaled or pulsed and interpreting the feedback information from the columns. By way of example, if the controller 80 is generating pulse signals at row ROW3, and a touch signal is being identified at column COL2, then key K10 is being touched.

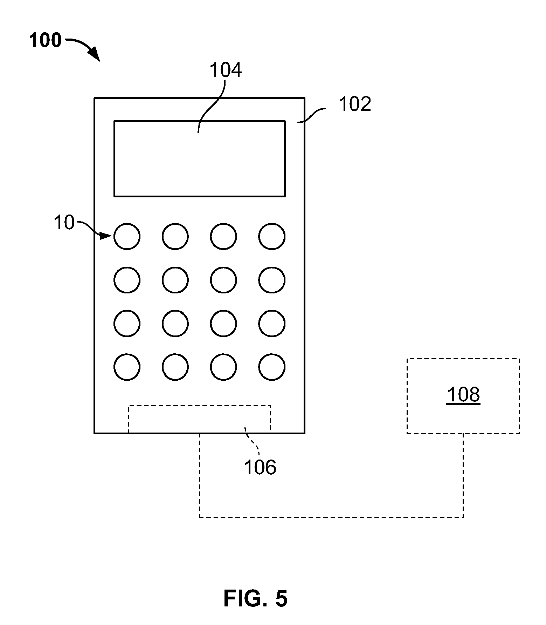

Figure 5 is a schematic view of an exemplary device 100 using the touch sensor 10. The device 100 includes a housing 102 holding the touch sensor 10. Optionally, the device 100 may include a display 104. The device 100 may include an internal controller 106, shown in phantom in Figure 4. The device 100 may communicate with a secondary device, machine or system 108 via a wired connection or a wireless connection. Touches at the touch sensor 10 may be used to control the device 100 and/or the secondary device, machine or system 108.

A touch sensor 10 is thus provided that operates in a cost effective and reliable manner. The touch sensor 10 includes a keyboard having keys arranged in a matrix of rows and columns. The keys include control circuitry including a transistor for detecting a touch situation. The touch sensor 10 is operated using a controller 40 that generates pulse signals. The controller 40 sends the pulsed signals to a single one of the rows and the controller analyzes a touch signal from a single one of the columns to determine if a touch has occurred. As such, a touched key can be uniquely identified by the controller 40. Moreover, the pulsed signal is used to power the transistor such that, only the transistors in the row being pulsed are powered at any one time. As such, the touch signal received at the column can uniquely identify the key being touched.

While the invention has been described in terms of various specific embodiments, those skilled in the art will recognize that the invention can be practiced with modification within the spirit and scope of the claims.

## Claims

1. A touch sensor comprising:
a keyboard having a key defining a touch sensing location;
control circuitry associated with the key, wherein the control circuitry includes a transistor, the key controls the transistor based on a touch event;
a pulse signal generator connected to the control circuitry and generating pulsed signals for transmission to the control circuitry, wherein the pulsed signals power the transistor, the transistor outputs a touch signal when a touch event occurs at the associated key and the transistor outputs a non-touch signal when no touch event occurs at the associated key; and
an analyzer connected to the control circuitry and receiving from the transistor one of the touch signal indicating the touch event and the non-touch signal indicating the no touch event.

2. A touch sensor in accordance with claim 1 wherein the transistor outputs the touch signal and the no-touch signal after the transistor is powered by the pulsed signals.

3. A touch sensor in accordance with claim 1 wherein the transistor is un-powered and provides no output to the analyzer between pulse signals.

4. A touch sensor in accordance with claim 1 wherein a base of the transistor is capacitively coupled to the user when the user is touching the touch sensing location.

5. A touch sensor in accordance with claim 1 wherein a current passing through the transistor is different during the touch event than during the no touch event.

6. A touch sensor in accordance with claim 1 wherein the analyzer compares one of a capacitance change between the touch signal and the non-touch signal, an amplitude of the touch signal with an amplitude of the non-touch signal, and a time for the touch signal to reach a predetermined value with a time for the non-touch signal to reach the same predetermined value.

7. A touch sensor in accordance with claim 1 further comprising a supply voltage connected to the control circuitry and a supply element connected to the control circuitry and the supply voltage, the pulse signal generator is connected to a base of the supply element, wherein the pulsed signals activate the supply element to connect the supply voltage and the control circuitry of the key.

8. A touch sensor in accordance with claim 7 wherein the supply element is one of a transistor and a operational amplifier.

9. A touch sensor in accordance with claim 7 further comprising a first supply voltage and a second supply voltage.

10. A touch sensor in accordance with claim 1 wherein the control circuitry is connected to earth ground, the analyzer compares a capacitance change of the touch signal to earth ground to determine if the touch signal is a faulty touch signal.
